(19) Europäisches Patentamt
European Patent Office
Office européen des brevets

(11) Veröffentlichungsnummer: **0 086 930**
**A2**

(12) # EUROPÄISCHE PATENTANMELDUNG

(21) Anmeldenummer: 83100050.0

(22) Anmeldetag: 05.01.83

(51) Int. Cl.$^3$: **C 23 C 15/00**

(30) Priorität: 19.02.82 DE 3205919

(43) Veröffentlichungstag der Anmeldung: 31.08.83 Patentblatt 83/35

(84) Benannte Vertragsstaaten: AT BE CH DE FR GB IT LI LU NL SE

(71) Anmelder: **Firma Carl Freudenberg**
**Höhnerweg 2**
**D-6940 Weinheim/Bergstrasse(DE)**

(71) Anmelder: **Leybold-Heraeus GmbH**
**Bonner Strasse 504 Postfach 51 07 60**
**D-5000 Köln 51(DE)**

(72) Erfinder: **Hartwig, Peter, Dr.**
**Hohensachsenerstrasse 21**
**D-6945 Hirschberg 1(DE)**

(72) Erfinder: **Münz, Wolf-Dieter, Dr.-Phil.**
**Im Schwalbengrund 25**
**D-6463 Somborn 1(DE)**

(74) Vertreter: **Weissenfeld-Richters, Helga, Dr.**
**Höhnerweg 2**
**D-6940 Weinheim/Bergstrasse(DE)**

(54) **Verfahren zum Herstellen dünner Schichten auf Substraten durch Katodenzerstäuben.**

(57) Die Erfindung betrifft ein Verfahren zur Herstellung dünner Schichten auf Substraten durch Katodenzerstäuben von Targets aus Stoffen mit Elementen, die Atomgewichte gleich oder unterhalb 40 aufweisen, in Anwesenheit mindestens eines Inertgases.

Zur Lösung der Aufgabe, derartige Targetmaterialien wirtschaftlich zerstäuben und in Schichten mit entsprechender Stöchiometrie der Targetkomponenten umwandeln zu können, wird erfindungsgemäß vorgeschlagen, daß man als Inertgas ein Gas mit einem Atomgewicht gleich oder unterhalb 30 verwendet, insbesondere ein Gas oder Gasgemisch aus der Gruppe Helium und Stickstoff.

Das Verfahren ist anwendbar zum Herstellen dünner Schichten aus Oxiden, Nitriden, Karbiden, Chloriden und Fluoriden mindestens eines der Elemente Lithium, Bor, Magnesium und Aluminium. Das Verfahren ist insbesondere geeignet für die Herstellung von Festelektrolytschichten für galvanische Zellen aus wenigstens einem Lithium-Nitrid-Halogenid.

EP 0 086 930 A2

Carl Freudenberg
Postfach 13 69

D-6940 Weinheim / Bergstraße

LEYBOLD-HERAEUS GmbH
Bonner Straße 504

D-5000 Köln - 51

---

" Verfahren zum Herstellen dünner Schichten auf Substraten durch Katodenzerstäuben "

---

Die Erfindung betrifft ein Verfahren zum Herstellen dünner Schichten auf Substraten durch Katodenzerstäuben von Targets aus Stoffen mit Elementen, die Atomgewichte gleich oder unterhalb 40 aufweisen, in Anwesenheit mindestens eines Inertgases.

Die Verwendung des Katodenzerstäubungsprozesses zum Beschichten von Substraten mit dem Targetmaterial oder einem Reaktionsprodukt des Targetmaterials ist seit langem bekannt. Zwischen dem Target und dem Targethalter einerseits und einer Gegenelektrode andererseits, die meist durch den Substrathalter mit den Substraten gebildet wird, wird bei einem geeigneten Druck des anwesenden Gases, der unterhalb $10^{-1}$ mbar liegt, eine Glimmentladung gezündet und aufrechterhalten. Die hierdurch ionisierten Gasatome treffen auf das Target auf und schlagen aus diesem Atome des Targetmaterials heraus, die sich in Richtung der Substrate bewegen und auf diesen in Form einer zusammenhängenden Schicht kondensieren.

Die Anwendung des Verfahrens für eine Vielzahl von Endprodukten ist gleichfalls bekannt. So wird das betreffende Verfahren zur Herstellung von Elektronikbauteilen (Mikroschaltungen), zur Beschichtung von Folien und Glasscheiben mit leitfähigen Schichten und/oder optisch wirksamen Dünnschichten angewandt. Bekannt ist auch die Beschichtung von optischen Bauteilen (Linsen, Spiegel) mit dielektrischen Ein- und Mehrfachschichten, um beispielsweise Filter und/oder Antireflexeigenschaften zu erzeugen.

Es ist auch bekannt, daß neben Stickstoff auch die Edelgase Helium, Neon, Argon, Krypton und Xenon als plasmabildende Gase beim Zerstäubungsprozeß verwendet werden können. Sofern es darum geht, oxidische bzw. dielektrische Schichten zu erzeugen, werden dem Zerstäubungsgas geringe Mengen eines reaktiven Gases (im vorliegenden Falle Sauerstoff) zugesetzt

Hierbei geht die Empfehlung allerdings stets in der Richtung, als Zerstäubungsgas ein Gas mit einem hohen Atomgewicht einzusetzen, wie Argon (40), Krypton (84) und Xenon (131). Die in Klammern gesetzten Zahlen geben die abgerundeten Atomgewichte an. So wird beispielsweise von den Verfassern E. Hechtel, J. Bodanski und J. Roth in "Proceedings of the Symposium on Sputtering", Perchtoldsdorf/Vienna 1980, April 28 - 30, eine Kurvendarstellung gezeigt, in der die Zerstäubungsraten über dem Atomgewicht der genannten Edelgase dargestellt sind, und zwar als Parameterdarstellung für verschiedene Zerstäubungsspannungen. Die Kurvendarstellung läßt erkennen, daß die Zerstäubungsrate bei Atomgewichten unterhalb etwa 30, d.h. unterhalb des Atomgewichts von Argon (40) in einem Bereich mehrerer Zehnerpotenzen steil abfällt. Speziell für Helium liegt der Abfall zwischen einer und drei Zehnerpotenzen. Man war daher stets bestrebt, zur Erzielung einer ausreichenden Zerstäubungsrate Gase mit Atomgewichten von mindestens 40 einzusetzen, wobei in aller Regel Argon wegen seines verhältnismäßig niedrigen Preises bevorzugt wurde.

Nun wurde bei der sogenannten nicht-reaktiven Hochfrequenz-Zerstäubung von Oxiden wie Quarz etc. sowie bei der Hochfrequenz- und Gleichspannungs-Zerstäubung stöchiometrischer Nitride und Karbide beobachtet, daß an den Substraten stets ein Mangel (Unterstöchiometrie) der leichteren Sauerstoff-, Stickstoff- oder Kohlenstoff-Atome auftrat, so daß dem inerten Trägergas (Argon) stets geringe Mengen von Sauerstoff, Stickstoff oder Methan zugefügt werden mußten, um eine brauchbare Stöchiometrie in den kondensierten Schichten zu erzielen.

Bei der Herstellung von Schichten mit den leichten Elementen Lithium (6,9), Bor (10,8), Magnesium (24,3) und Aluminium (27) wurde beobachtet, daß auch bezüglich dieser Elemente ein Mangel an den Substraten auftrat, wenn gleichzeitig, d.h. aus einem Target aus mehreren Komponenten, Stoffe mit einem höheren Atomgewicht zerstäubt wurden. Hierbei wurde die Unterstöchiometrie um so stärker, je größer das Atomgewicht der gleichzeitig zerstäubten anderen Komponente war. Dies war der Fall, obwohl eine entsprechende Menge des Targetmaterials ganz offensichtlich zerstäubt wurde.

Ähnlich ungünstige Kondensationsverhältnisse wurden bei der Zerstäubung von Verbindungen aus ausschließlich leichten Atomen wie Magnesiumfluorid festgestellt. Auch hierbei entstand neben einer sehr niedrigen Kondensationsrate in der kondensierten Schicht eine kaum beherrschbare Mißstöchiometrie. Die genannten Elemente galten daher als nicht oder schwer zerstäubbare Materialien.

In einem ganz besonders gravierenden Fall einer Lithium-Verbindung wurde sogar beobachtet, daß Lithium als das leichteste Metallatom im periodischen System (6,9) unter den üblichen Zerstäubungsbedingungen überhaupt nicht am Substrat ankam, so daß auch keinerlei Kondensation erfolgte.

Der Erfindung liegt daher die Aufgabe zugrunde, ein Verfahren der eingangs beschriebenen Art anzugeben, d.h. ein solches Verfahren, mit dem auch Targetmaterialien mit Atomgewichten gleich oder unterhalb 40 wirtschaftlich zerstäubt und in Schichten umgewandelt werden können.

Die Lösung der gestellten Aufgabe erfolgt erfindungsgemäß dadurch, daß man bei der Zerstäubung derartiger Materialien, zu denen die Elemente Lithium, Bor, Magnesium und Aluminium gehören, als Inertgas ein Gas mit einem Atomgewicht gleich oder unterhalb 30 verwendet. In ganz besonderer Weise haben sich zur Lösung der Aufgabe Stickstoff und (bevorzugt) Helium erwiesen.

Bei der erfindungsgemäßen Kombination von Targetmaterial und Zerstäubungsgas wurde überraschend festgestellt, daß trotz einer ausreichend hohen Zerstäubungs- und Kondensationsrate am Substrat stöchiometrische Verhältnisse erzielt werden konnten, ohne daß besondere Eingriffe in den Gashaushalt einerseits oder in die Targetzusammensetzung andererseits vorgenommen werden mußten.

Es kann vermutet werden, daß bei der Katodenzerstäubung gleicher Atome mit einem Atomgewicht von 40 oder darunter in einem teilweise ionisierten Gas mit einem Atomgewicht von 40 oder darüber (beispielsweise Argon) die aus dem Target herausgeschlagenen Atome auf dem Weg zum Substrat durch elastische Stösse mit den in relativ hoher Konzentration vorhandenen Trägergasatomen getrennt und am Transport zum Substrat gehindert werden. Diesbezüglich schafft nun die Erfindung Abhilfe, so daß nunmehr bisher als unzerstäubbar geltende Materialien bei der Katodenzerstäubung verwendet werden können, wie insbesondere Lithium, Bor und Magnesium. Speziell das Magnesiumfluorid stellt ein sehr brauchbares niederbrechendes Dielektrikum für die Herstellung harte transparenter Dünnschichten auf dem Gebiet der Optik dar.

Derartige Schichten können nunmehr durch den Erfindungsgegenstand in großtechnischem Maßstab wirtschaftlich hergestellt werden.

Eine ganz besondere Bedeutung kommt dem erfindungsgemäßen Verfahren jedoch bei der Herstellung von dünnen Schichten aus Lithiumnitridhalogeniden zu. Lithiumnitridhalogenide haben sich insbesondere als Festelektrolyte für leichte Batterien sehr bewährt. Die Herstellung der erforderlichen

extrem dünnen Festelektrolytschichten stößt jedoch auf große Schwierigkeiten. Die dünne Schicht ist deshalb notwendig, weil die Dicke des Elektrolyten proportional dem ionischen Widerstand der Schicht ist. Beim Verpressen der Lithiumverbindungen erhält man abhängig von der Unterlage und dem Preßdruck nur bedingt dünne Schichten. Schichtdicken kleiner als etwa 100µm sind nicht lochfrei zu erreichen. Bei einem Elektrolytwiderstand von $10^6$ Ω/cm² erhält man theoretisch einen spezifischen Widerstand von $10^4$ Ω/cm², wenn die Dicke der Schicht 100 µm beträgt. Dieser Wert läßt sich jedoch praktisch nicht erreichen, weil kein Preßgrad von 100 % vorliegt und außerdem Korngrenzenwiderstände auftreten. Ein Widerstand von $10^4$Ω/cm² ist für viele Anwendungen bereits zu hoch, zumal der Gesamtwiderstand einer Zelle noch zusätzlich alle Widerstände in den Elektroden enthält.

Da die Herstellung flacher Schichten durch Pressen somit sehr aufwendig ist und bezüglich der Schichtdicke schnell eine Grenze erreicht ist, besteht ein großes Bedürfnis nach extrem dünnen Elektrolytschichten, die einerseits sehr leicht sind, d.h. Lithiumverbindungen als festen Elektrolyten enthalten und andererseits eine Schichtdicke von weniger als 100 µm und möglichst noch unter 10 µm aufweisen sollen.

Bezüglich dieses Schichtmaterials liegt der Erfindung die weitere Aufgabe zugrunde, ein Verfahren zu entwickeln, das die Herstellung von extrem dünnen, d.h. unter 10 µm liegenden Schichten von Lithiumnitridhalogeniden gestattet. Hierbei ist es wesentlich, daß diese extrem dünnen Schichten

mechanisch widerstandsfähig sind und daß der Elektrolyt in kompakter, d.h. nicht durch Fehlstellen unterbrochener Schicht vorliegt.

Die Lösung dieser speziellen Aufgabe erfolgt gemäß der weiteren Erfindung dadurch, daß das bzw. die Lithiumnitridhalogenid(e) bei einem Druck unterhalb $10^{-1}$ mbar aus einem gepreßten und/oder gesinterten Target bei einer Entladungsspannung von wenigstens 300 Volt zerstäubt und als kompakte, festhaftende dünne Schicht auf den Substraten abgeschieden wird, und daß als plasmaerzeugendes Gas ein wenigstens 55 Gewichtsprozent Helium und/oder Stickstoff enthaltendes Gas verwendet wird.

Die derart hergestellten elektrolytischen Zellen zeichnen sich durch eine außergewöhnlich geringe Selbstentladung aus. Dadurch ergibt sich eine erheblich verlängerte Lagerfähigkeit.

Die festen Elektrolyten auf Lithiumnitridhalogenidbasis sind homogene anorganische Stoffe. Obgleich alle Lithiumnitridhalogenide feste Ionenleiter sind, wird die Verbindung $Li_9N_2Cl_3$ ganz besonders bevorzugt. Darüber hinaus lassen sich mit großem Vorteil weitere Lithiumnitridhalogenide verarbeiten. Bewährt haben sich insbesondere Lithiumverbindungen, die in der DE-OS 29 01 301 und der DE-OS 29 18 940 beschrieben werden.

Das erfindungsgemäße Verfahren verwendet an sich bekannte Katodezerstäubungsanlagen, wie sie zum Beschichten von zahlreichen Trägermaterialien insbesondere mit Metallen oder Metall-Legierungen bekannt sind. Diese Katodenzerstäubungsanlagen gestatten es, Metalle mit hohem Schmelzpunkt in einfacher Weise und mit ausgezeichneter Haftfestigkeit auf die Substrate aufzubringen. Außer bei Metallen hat sich das Verfahren zur Beschichtung mit Oxiden, Nitriden und Carbiden, Chloriden, Fluoriden bewährt. Als plasmaerzeugendes Gas wird üblicherweise Argon eingesetzt.

Die hier gewonnenen Erfahrungen lassen sich nicht auf die erfindungsgemäßen Lithiumnitridhalogenide übertragen, weil die Reaktivität der Komponenten eine bedeutende Rolle spielt. Nicht nur die hohe Temperatur, die z.B. beim Zerstäuben der Metalle, Oxide, Nitride und Carbide auftritt, ist nachteilig, es hat sich überdies herausgestellt, daß bei Verwendung von Argon als plasmaerzeugendes Gas in einem unvertretbar hohen Zeitraum nur geringe Mengen der Lithiumnitridhalogenide auf dem Substrat niedergeschlagen wurden.

Überraschenderweise wurde dagegen gefunden, daß bei Verwendung von Helium und/oder Stickstoff als wesentlichen

Bestandteil enthaltenden plasmaerzeugenden Gasen bei einer Entladungsspannung von bereits wenig über 200 Volt sehr kompakte fest haftende dünne Schichten in kurzer Zeit abgeschieden werden.

Während man bei Verwendung von Argon als plasmaerzeugendes Gas nur Raten von etwa 0,3 Å/s erzielt, die für die vorliegende Anwendung völlig unzureichend sind, erhält man bei Verwendung von Helium statt Argon eine Schichtwachstumsrate von etwa 5 Å/s. Bei Argon würde man somit für eine 1 µm starke Schicht eine Beschichtungszeit von etwa 9 Stunden benötigen, während bei Verwendung von Helium für die gleiche Schichtdicke nur 30 Minuten erforderlich sind.

Verwendet man dagegen Helium und/oder Stickstoff als wesentlichen Bestandteil des plasmaerzeugenden Gases, so führt dies bei kurzen Beschichtungszeiten zu qualitativ sehr hochwertigen dünnen Schichten. Erfindungsgemäß können sowohl Mischungen verwendet werden, die wenigstens 55 Gewichtsprozent Helium und/oder Stickstoff enthalten als auch die Gase Helium und/oder Stickstoff in reiner Form. Bevorzugt wird erfindungsgemäß die Verwendung von Helium. Wegen der Leichtigkeit der Heliumatome werden diese bei Zusammenstößen bevorzugt abgelenkt. Es ist erstaunlich, daß der geringe Impuls der Heliumteilchen ausreicht, um Material aus dem Lithiumnitridhalogenid-Target herauszuschlagen.

Ebenfalls sehr gute Ergebnisse bringen Mischungen aus Helium und Stickstoff, wobei die optimale Zusammensetzung jeweils dem entsprechenden Targetmaterial angepaßt werden kann.

Sowohl bei der Verwendung von Helium als auch bei geeigneten Helium-Stickstoff-Mischungen ist es gegebenenfalls sogar günstig, wenn geringe Mengen Argon in dem plasmaerzeugenden Gas vorhanden sind. Diese geringe Mengen können beispielsweise als Verunreinigungen im Helium vorhanden sein oder durch vorheriges Spülen der Anlage in in diese hineingelangen, oder sogar bewußt hinzugegeben werden.

Für die Beschichtungsdauer ist auch die Herstellung des Targets von Bedeutung. Es ist möglich, bei einem druckgesinterten Targetmaterial bei sonst gleichen Bedingungen die Beschichtungsdauer gegenüber einem in üblicher Weise gepreßten Target noch erheblich zu vermindern.

Das erfindungsgemäße Verfahren kann sowohl unter Verwendung von Gleichstrom (sogenanntes DC-Sputtern) oder von Wechselstrom (HF- oder RF-Sputtern) durchgeführt werden, zweckmäßig kann unter Anlegen eines Magnetfeldes gearbeitet werden (Magnetronsputtern). Ein Magnetron wird in seiner einfachsten Form dadurch gebildet, daß man hinter einem plattenförmigen Target in sich geschlossene Polschuhsysteme eines Magnetfelderzeugers derart anordnet, daß sämtliche Magnetfeldlinien des einen Polsystems aus der Targetoberfläche austreten und nach dem Durchlaufen bogenförmiger Bahnen an einer anderen Stelle oberhalb des anderen Polschuhsystems wieder in die Targetoberfläche eintreten, so daß auf diese Weise mindestens ein geschlossener magnetischer "Tunnel" gebildet wird. Derartige Magnetrons sind seit langem Stand der Technik.

Galvanische Zellen, die Lithiumnitridhalogenide als Festelektrolyt enthalten, lassen sich in sehr kleinen Abmessungen herstellen. So ist es möglich, nach dem erfindungsgemäßen Verfahren Lithiumnitridhalogenidschichten im Bereich von einigen Nanometern bis zu einigen Mikrometern herzustellen. Damit eröffnen sich für das erfindungsgemäß hergestellte Material neue Anwendungsgebiete, z.B. bei Memoryelementen und elektrochromen Displays. Mit den erfindungsgemäß hergestellten Festelektrolytschichten lassen sich Allfeststofflithiumzellen mit Widerständen von deutlich kleiner als 1 k $\Omega/cm^2$ bauen.

Die nachfolgenden Beispiele dienen zur Erläuterung der Erfindung.

Beispiel 1 (Vergleichsbeispiel):

In einer handelsüblichen Katodenzerstäubungsanlage des Typs Z400 (Hersteller: Leybold-Heraeus GmbH) wurde die gleichfalls handelsübliche und mit einem Hochfrequenzgenerator verbundene Magnetronkatode vom Typ PK75 (Hersteller: Leybold-Heraeus GmbH) mit einer heißgepreßten Targetplatte aus Magnesiumfluorid mit einem Durchmesser von 75 mm und einer Dicke von 5 mm bestückt. Auf einem im Abstand von 45 mm gegenüberliegenden Substrathalter befanden sich scheibenförmige Substrate aus Glas mit einem Durchmesser von 20 mm, auf denen eine Magnesiumfluoridschicht erzeugt werden sollte.

Die Anlage wurde evakuiert und anschließend mit Argon bis zu einem Druck von 8 x $10^{-3}$ mbar geflutet. Der Zer-

stäubungsprozeß wurde gezündet und bei einer Zerstäubungsspannung von 250 V betrieben. Die spezifische Katodenbelastung betrug 1,7 W/cm². Die mit einem Schwingquarz gemessene Wachstumsrate der Schicht betrug etwa 0,4 Å/sec. Der Zerstäubungsprozeß wurde über die Dauer von 10 min. aufrechterhalten, bis eine Schicht von 0,024 µm entstanden war. Eine Messung mit dem Auger-Spektrometer ergab eine drastische Unterstöchiometrie des Fluors entsprechend einer Summenformel $Mg_{1,5}F$.

<u>Beispiel 2:</u>

Der Versuch nach Anspruch 1 wurde mit dem Unterschied wiederholt, daß anstelle von Argon nunmehr ein Gemisch aus Helium und Argon im Verhältnis 10:2 als Zerstäubungsgas eingeleitet wurde. Bei ansonsten gleichen Verfahrensparametern einschließlich einer spezifischen Katodenbelastung von 1,7 W/cm² stellte sich eine Zerstäubungsspannung von 280 V ein. Die mit einem Schwingquarz gemessene Wachstumsrate der Schicht betrug nunmehr 3 Å/sec. Nach einer gesamten Zerstäubungsdauer von 10 min. ergab sich eine Schichtdicke von 0,18 µm. Eine Analyse der Schichtzusammensetzung führte zu dem Ergebnis, daß die Unterstöchiometrie wesentlich verringert wurde, und zwar entsprechend einer Summenformel $Mg_{1,05}F$.

<u>Beispiel 3 (Vergleichsbeispiel):</u>

In eine handelsübliche Katodenzerstäubungsanlage wird ein Target aus gepreßtem Lithiumnitridchlorid ($Li_9N_2Cl_3$) eingebaut. Die Anlage wird evakuiert und anschliessend mit Argon bis $1 \times 10^{-2}$ mbar geflutet. Das Plasma wird gezündet und Hochspannung (800 V) angelegt. Es fließt ein Katodenstrom von 80 mA. Die mit einem Schwingquarz gemessene Wachstumsrate der Schicht beträgt 0,2 bis 0,3 Å/sec.

Bei Anlegen einer höheren Spannung wird das Targetmaterial zu heiß und tropft ab. Beim Ausbau des Targets nach etwa 15 Minuten fällt auf, das ein erheblicher Teil abgetragen ist, ohne daß sich auf dem Substrat eine entsprechende Schicht gebildet hätte. Offensichtlich ist das Lithiumnitridchlorid zwar abgetragen worden, aber fast kein Material am Substrat angekommen. Vermutlich ist dies auf Stöße mit den Argonatomen des Plasma zurückzuführen, die die Targetteilchen abgelenkt haben.

Beispiel 4:

Bei genau gleicher Versuchsanordnung wie in Beispiel 1 wird statt Argon nunmehr Helium als plasmaerzeugendes Gas verwendet.

Das Targetmaterial wird abgetragen und eine Schichtwachstumsrate von etwa 5 Å/s auf dem Substrat erzielt. Damit verkürzt sich die Beschichtungszeit für eine 1 µm starke Schicht auf etwa 3o Minuten.

Beispiel 5:

Es wird bei sonst gleichen Versuchsbedingungen wie in Beispiel 2 statt des normal gepreßten Targets ein druckgesintertes Targetmaterial verwendet. Die Schichtraten lassen sich auf etwa 3o Å/s erhöhen. Dies entspricht einer Beschichtungsdauer von weniger als 6 Minuten für 1 µm Schichtdicke.

Das druckgesinterte Targetmaterial wurde hergestellt durch Sintern eines bei 3o MPa und 3oo °C gepreßten Materials.

Das normal gepreßte Target wurde durch einfaches Zusammenpressen bei Raumtemperatur bei 3o MPa hergestellt.

Beispiel 6 :

Bei gleicher Versuchsanordnung wie in den vorstehenden Beispielen beschrieben wird nunmehr ein Gemisch aus Helium und Stickstoff als plasmaerzeugendes Gas verwendet. Das Target besteht wiederum aus Lithiumnitridchlorid. Bei sonst gleichem Versuchsaufbau wie in Beispiel 2 werden folgende Wachstumsraten in Abhängigkeit vom Stickstoffpartialdruck enthalten:

| $P_{He}$ (mbar) | $P_{N_2}$ (mbar) | Schichtwachstum (Å/s) |
|---|---|---|
| $8 \times 10^{-3}$ | - | 3 |
| $8 \times 10^{-3}$ | $1 \times 10^{-3}$ | 5 |
| $8 \times 10^{-3}$ | $2 \times 10^{-3}$ | 5 |
| $8 \times 10^{-3}$ | $4 \times 10^{-3}$ | 4 |
| $8 \times 10^{-3}$ | $8 \times 10^{-3}$ | 3 |

Beispiel 7 :

Mit einer gemäß Beispiel 3 hergestellten Festelektrolytschicht wurden Zellen folgenden Typs aufgebaut:

$$CuS/Li_9N_2Cl_3/Li$$

Die Schichtdicke von $Li_9N_2Cl_3$ beträgt 1 µm. Es wird ein Lithiumstück mit 1o mm Durchmesser dagegengepreßt. Man erhält so eine Spannung von 2,4 Volt. Es fließt ein Kurzschlußstrom von 7oo µA.

P A T E N T A N S P R Ü C H E:

1. Verfahren zum Herstellen dünner Schichten auf Substraten durch Katodenzerstäuben von Targets aus Stoffen mit Elementen, die Atomgewichte gleich oder unterhalb 40 aufweisen, in Anwesenheit mindestens eines Inertgases, dadurch gekennzeichnet, daß man als Inertgas ein Gas mit einem Atomgewicht gleich oder unterhalb 30 verwendet.

2. Verfahren nach Anspruch 1, dadurch gekennzeichnet, daß man als Inertgas ein Gas oder Gasgemisch aus der Gruppe Helium (4) und Stickstoff (14) verwendet.

3. Anwendung des Verfahrens nach Anspruch 1 zum Herstellen dünner Schichten aus Oxiden, Nitriden, Karbiden, Chloriden, Fluoriden mindestens eines der Elemente Lithium (6,9), Bor (10,8), Magnesium (24,3), Aluminium(27).

4. Verfahren nach Anspruch 1 zum Herstellen von Festelektrolytschichten für galvanische Zellen, wobei der Festelektrolyt eine sehr dünne, zusammenhängende Schicht aus wenigstens einem Lithiumnitridhalogenid ist, dadurch gekennzeichnet, daß das bzw. die Lithiumnitridhalogenid(e) bei einem Druck unterhalb $10^{-1}$ mbar aus einem gepreßten und/oder gesinterten Target bei einer Entladungsspannung von wenigstens 300 Volt zerstäubt und als kompakte, fest haftende dünne Schicht auf den Substraten abgeschieden

wird, und daß als plasmaerzeugendes Gas ein wenigstens 55 Gewichts-Prozent Helium und/oder Stickstoff enthaltendes Gas verwendet wird.

5. Verfahren nach Anspruch 4, <u>dadurch gekennzeichnet</u>, daß daß $Li_9N_2Cl_3$ als Targetmaterial verwendet wird.